# EUROPÄISCHE PATENTSCHRIFT

(11) **EP 0 541 878 B1**
(45) Veröffentlichungstag und Bekanntmachung des Hinweises auf die Patenterteilung: **03.04.1996**
(21) Anmeldenummer: 91810875.4
(22) Anmeldetag: 13.11.1991
(51) Int. Cl.: H03M 1/60, H03M 3/02

(54) **Delta-Sigma-Analog/Digital-Wandler**
Delta sigma analog to digital converter
Convertisseur analogique/numérique Delta-Sigma

(43) Veröffentlichungstag der Anmeldung: 19.05.1993
(73) Patentinhaber: Endress + Hauser Flowtec AG, CH-4153 Reinach BL 1 (CH)
(72) Erfinder: Budmiger, Thomas, CH-4107 Ettingen (BL) (CH)
(74) Vertreter: Morstadt, Volker, Dipl.-Ing. c/o Endress + Hauser Flowtec AG

(56) Entgegenhaltungen:
- GB-A- 2 201 057
- US-A- 3 659 288
- US-A- 3 877 020
- US-A- 4 584 566

## Beschreibung

Die Erfindung besteht nach Anspruch 1 in einem Delta-Sigma-Analog/Digital-Wandler mit: einem Integrierglied, dessen Signaleingang über einen Integrierwiderstand ein zu wandelndes Analogsignal zugeführt ist; einem Komparator, dessen Komparator-Eingang am Ausgang des Integrierglieds und dessen Referenzeingang am Schaltungsnullpunkt liegt; einem Pulsbreitenwähler, der in Abhängigkeit vom Pegel des Ausgangssignals des Komparators einen schmalen oder einen breiten Impuls erzeugt, dessen Signaleingang am Ausgang des Komparators; liegt und dessen erstem Takteingang ein Taktsignal sowie dessen zweitem Takteingang ein durch Frequenzteilung (Teilungszahl n > 3 ) aus dem Taktsignal abgeleitetes Zusatztaktsignal zugeführt ist; und einer Serienschaltung eines ersten und eines zweiten elektronischen Schalters, die entweder zwischen einer unipolaren Referenzspannung und dem Schaltungsnullpunkt oder zwischen den beiden Polen einer bipolaren, schaltungsnullpunkt-symmetrischen Referenzspannung liegt, bei der der Steuereingang des ersten elektronischen Schalters am nichtinvertierten und der des zweiten elektronischen Schalters am invertierten Ausgang des Pulsbreitenwählers liegt und bei der der Verbindungspunkt der elektronischen Schalter mit einer Weiterverarbeitungsanordnung sowie über einen Rückkopplungswiderstand mit dem Signaleingang des Integrierglieds verbunden ist, wobei entweder dem Referenzeingang des Integrierglieds im Falle der unipolaren Referenzspannung derjenige Teilbetrag zugeführt ist, der gleich [Ri/(Ri+Rk)]Uu/2 ist, oder der Referenzeingang im Falle der bipolaren Referenzspannung am Schaltungsnullpunkt liegt und wobei die Breite des vom Pulsbreitenwähler erzeugten schmalen Impulses gleich der Periodendauer des Taktsignals und wobei die Breite des vom Pulsbreitenwähler erzeugten breiten Impulses gleich der (n - 1)fachen Periodendauer des Taktsignals ist.

Die Erfindung besteht nach Anspruch 2 ferner in einem Delta-Sigma-Analog/Digital-Wandler mit: einem Integrierglied, dessen Signaleingang über einen Integrierwiderstand ein zu wandelndes Analogsignal zugeführt ist; einem Komparator, dessen Komparator-Eingang am Ausgang des Integrierglieds und dessen Referenzeingang am Schaltungsnullpunkt liegt; einem Pulsbreitenwähler, der in Abhängigkeit vom Pegel des Ausgangssignals des Komparators einen schmalen oder einen breiten Impuls erzeugt, dessen Signaleingang am Ausgang des Komparators liegt und dessen erstem Takteingang ein Taktsignal sowie dessen zweitem Takteingang ein durch Frequenzteilung (Teilungszahl n > 3 ) aus dem Taktsignal abgeleitetes Zusatztaktsignal zugeführt ist; und einem D-Flipflop, dessen D-Eingang mit dem Ausgang des Pulsbreitenwählers verbunden ist, dessen nichtinvertiertes Ausgangssignal über einen Rückkopplungswiderstand mit dem Eingang des Integrierglieds verbunden ist, dessen Takteingang das Zusatztaktsignal sowie dessen invertiertes Ausgangssignal einer Weiterverarbeitungsanordnung zugeführt ist und dessen Betriebsspannung entweder eine unipolare Referenzspannung oder eine bipolare, schaltungsnullpunkt-symmetrische Referenzspannung ist, wobei entweder dem Referenzeingang des Integrierglieds im Falle der unipolaren Referenzspannung derjenige Teilbetrag zugeführt ist, der gleich [Ri/(Ri+Rk)]Uu/2 ist, oder der Referenzeingang im Falle der bipolaren Referenzspannung am Schaltungsnullpunkt liegt und wobei die Breite des vom Pulsbreitenwähler erzeugten breiten Impulses gleich der (n - 1)fachen Periodendauer des Taktsignals ist.

In der Zeitschrift "rme", 1978, Seite 024 ist die einfachste Schaltung eines mit dem Gegenstand der Erfindung nach Anspruch 1 vergleichbaren, heute so genannten Delta-Sigma-Analog/Digital-Wandlers beschrieben.

Danach besteht diese Grundschaltung aus: einem Integrierglied, nämlich einen einfachen RC-Glied; einem Komparator, dessen Komparator-Eingang ein zu wandelndes Analogsignal zugeführt ist und dessen Referenzeingang am Verbindungspunkt von Widerstand und Kondensator des Integrierglieds liegt; einem D-Flipflop, dessen D-Eingang mit dem Ausgang des Komparators verbunden ist und dessen Takteingang ein Taktsignal zugeführt ist; einer Serienschaltung eines ersten und eines zweiten elektronischen Schalters, die zwischen der Referenzspannung und dem Schaltungsnullpunkt liegt, bei der der Steuereingang des ersten elektronischen Schalters am nichtinvertierten und der des zweiten elektronischen Schalters am invertierten Ausgang des D-Flipflops liegt und bei der der Verbindungspunkt der elektronischen Schalter auf den Signaleingang des Integrierglieds über den Widerstand des RC-Glieds zurückgekoppelt ist; und einer Weiterverarbeitungsanordnung, deren Eingang am nichtinvertierten Ausgang des D-Flipflops liegt.

In der US-A 39 55 191 ist die einfachste Schaltung eines mit dem Gegenstand der Erfindung nach Anspruch 2 vergleichbaren Delta-Sigma-Analog/Digital-Wandlers beschrieben.

Nach Fig. 5 der US-A 39 55 191 besteht diese Grundschaltung aus: einem RC-Glied als Integrierglied, dem über dessen Widerstand als Integrierwiderstand ein zu wandelndes Analogsignal zugeführt ist, und einem D-Flipflop, dessen D-Eingang am Verbindungspunkt von Widerstand und Kondensator des Integrierglieds liegt, dessen Takteingang ein Taktsignal zugeführt ist und dessen invertiertes Ausgangssignal auf diesen Verbindungspunkt über einen weiteren Widerstand zurückgekoppelt ist, welchem Verbindungspunkt auch eine Referenzspannung zugeführt ist.

Wird nach Fig. 7 der US-A 39 55 191 zwischen dem Eingang für das Analogsignal und dem Integrierglied ein Operationsverstärker derart eingefügt, daß dessen erster Eingang am Analogsignal und dessen zweiter Eingang am Schaltungsnullpunkt liegt, so kann der invertierte Ausgang des D-Flipflops zusätzlich auf diesen ersten Eingang über ein T-Glied aus zwei Widerständen und einem Kondensator zurückgekoppelt sein.

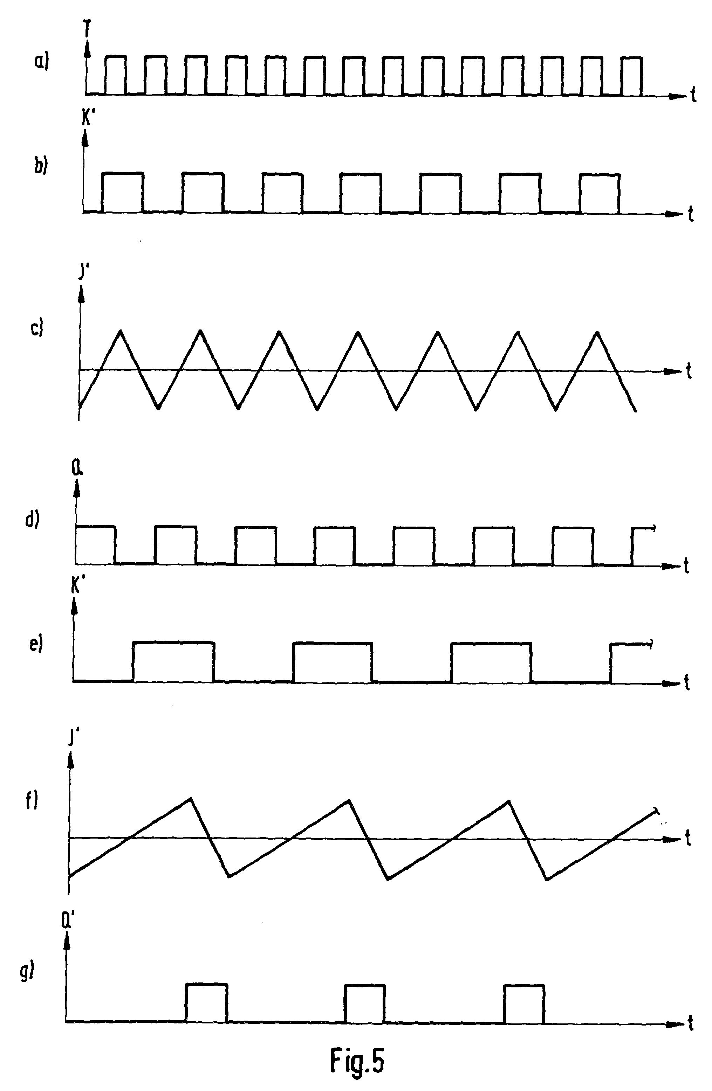

Eine wesentliche Eigenschaft des einfachen Delta-Sigma-Analog/Digital-Wandlers nach der oben genannten Zeitschrift "rme" besteht darin, daß die Anzahl der pro Zeiteinheit am Ausgang des Komparators entstehenden Polaritätswechsel, also deren Frequenz, von der Amplitude des zu wandelnden Analogsignals abhängt, und zwar derart, daß diese Frequenz gerade halb so groß wie die des Taktsignals, wenn die Analogsignal-Amplitude gleich der Hälfte der Referenzspannung ist, und von diesem Wert aus sowohl zu kleineren als auch zu größeren Amplituden hin proportional zur Amplitude abnimmt, vgl. auch unten die Erläuterung der Fig. 5.

Insb. bei hochfrequenten Taktsignalen verursachen die aufgrund der variablen Häufigkeit der Polaritätswechsel variablen Umschaltzeiten der im Ausgangskreis des Komparators angeordneten elektronischen Umschalter bzw. der Ausgangstransistoren des D-Flipflops beträchtliche Linearitätsfehler, so daß der erreichbaren Genauigkeit des üblichen Delta-Sigma-Analog/Digital-Wandlers enge Grenzen gesetzt sind. Außerdem sind diese Umschaltzeiten stark temperaturabhängig, was ebenfalls zum Linearitätsfehler beiträgt, aber praktisch nicht kompensierbar ist.

Die in den Ansprüchen definierte Erfindung dient der Lösung dieses Problems, und zwar umgeht der erfindungsgemäße Delta-Sigma-Analog/Digital-Wandler die geschilderte Problematik dadurch, daß aufgrund des zwischen Komparator und Serienschaltung der beiden Schalter bzw. zwischen Komparator und D-Flipflop angeordneten Pulsbreitenwählers die Frequenz der Polaritätswechsel am Ausgang des Komparators über den gesamten Amplitudenbereich des Analogsignals konstant und somit eine praktisch ideale Linearität erreichbar ist, die außerdem temperaturunabhängig ist.

In der US-A-3 877 020 wird eine ähnliche Lösung bei einem Spannungs-Frequenz-Wandler beschrieben.

Als Restfehler verbleibt lediglich eine Temperaturabhängigkeit der Verstärkung und des Offsets; erstere kann gemessen und, z.B. rechnerisch mittels eines Mikroprozessors, kompensiert werden, während letzterer durch Differenzbildung der Ausgangssignale des Delta-sigma-Analog/Digital-Wandlers leicht eliminierbar ist.

Die vier Varianten der Erfindung werden nun unter Bezugnahme auf die Figuren der Zeichnung näher erläutert, in der gleiche Teile mit denselben Bezugszeichen versehen sind.
- Fig. 1 zeigt: schematisch in Form eines Blockschaltbilds ein Ausführungsbeispiel der ersten Variante der Erfindung,
- Fig. 2 zeigt: schematisch in Form eines Blockschaltbilds ein Ausführungsbeispiel der zweiten Variante der Erfindung,
- Fig. 3 zeigt: schematisch in Form eines Blockschaltbilds ein Ausführungsbeispiel der dritten Variante der Erfindung,
- Fig. 4 zeigt: schematisch in Form eines Blockschaltbilds ein Ausführungsbeispiel der vierten Variante der Erfindung,
- Fig. 5 zeigt: verschiedene Zeitdiagramme von in einer Schaltung nach dem Stand der Technik bei zwei unterschiedlichen Amplituden der zu wandelnden Spannung auftretenden Kurvenformen, und
- Fig. 6 zeigt: verschiedene Zeitdiagramme von in einer Schaltung nach Fig. 2 bei zwei unterschiedlichen Amplituden der zu wandelnden Spannung auftretenden Kurvenformen.

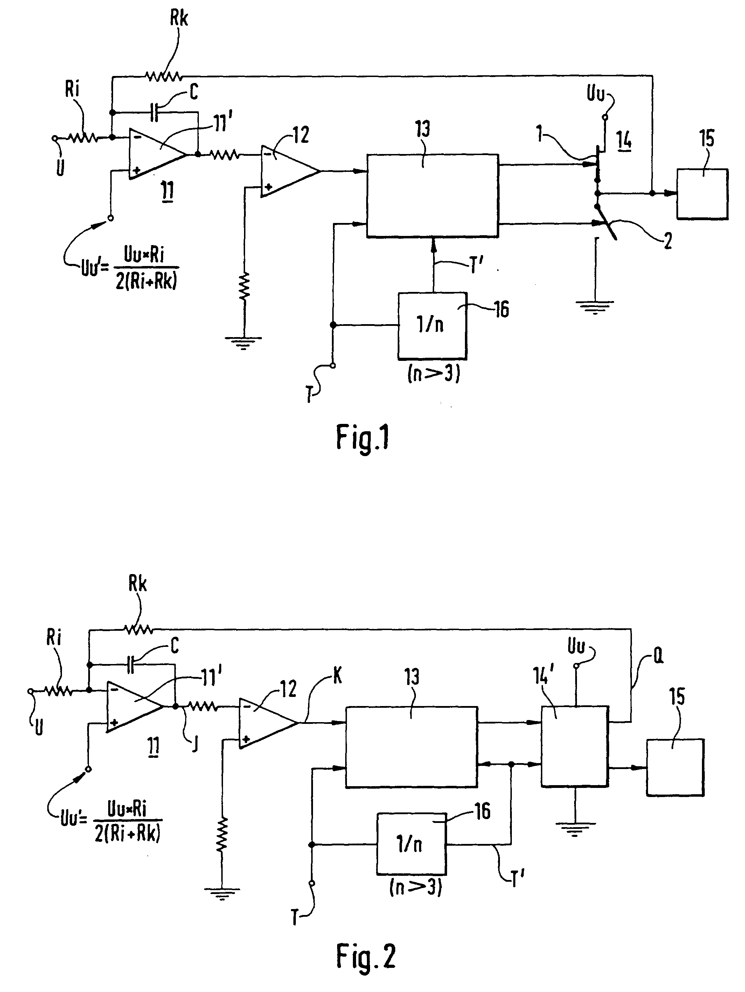

Beim Delta-Sigma-Analog/Digital-Wandler nach Fig. 1 ist einem Signaleingang eines Integrierglieds 11 über einen Integrierwiderstand Ri ein analog/digital zu wandelndes Analogsignal U zugeführt. Das Integrierglied 11 enthält im Ausführungsbeispiel der Fig. 1 einen Kondensator C und einen damit entsprechend beschalteten Operationsverstärker 11'.

Der Ausgang des Integrierglieds 11 liegt am Komparator-Eingang eines Komparators 12, der bevorzugt mittels eines weiteren Operationsverstärkers realisiert ist. Sein Referenzeingang liegt am Schaltungsnullpunkt.

Der Ausgang des Komparators liegt am signaleingang eines Pulsbreitenwählers 13, dessen erstem Takteingang ein Taktsignal T zugeführt ist, unter dessen Steuerung die Analog/Digital-Wandlung vorgenommen wird. Dem zweiten Takteingang des Pulsbreitenwählers ist ein durch Frequenzteilung (Teilungszahl n > 3 ) aus dem Taktsignal abgeleitetes Zusatztaktsignal T' zugeführt, das mittels des Frequenzteilers 16 erzeugt wird. Der Pulsbreitenwähler 13 erzeugt in Abhängigkeit vom Pegel des Ausgangssignals des Komparators 12 einen schmalen Impuls, dessen Breite gleich der Periodendauer des Taktsignals T ist, und einen breiten Impuls, dessen Breite gleich der (n -1)fachen Periodendauer des Taktsignals T ist.

Ferner ist eine Serienschaltung 14 eines ersten und eines zweiten elektronischen Schalters 1, 2 vorgesehen, die zwischen einer unipolaren Referenzspannung Uu und dem Schaltungsnullpunkt liegt. Der Steuereingang des ersten elektronischen Schalters 1 liegt am nichtinvertierten und der des zweiten elektronischen Schalters 2 am invertierten Ausgang des Pulsbreitenwählers 13. Der Verbindungspunkt der elektronischen Schalter 1, 2 ist über einen Rückkopplungswiderstand Rk mit dem Signaleingang des Integrierglieds 11 verbunden. An diesem Verbindungepunkt ist auch eine Weiterverarbeitungsanordnung 15 angeschlossen. Dem Referenzeingang des Integrierglieds 11 ist derjenige Teilbetrag der unipolaren Referenzspannung Uu zugeführt, der gleich [Ri/(Ri+Rk)]Uu/2 ist.

Die beiden elektronischen Schalter 1, 2 können mittels bipolarer Transistoren oder Feldeffekt-Transistoren, insb. mittels Isolierschicht-Feldeffekt-Transistoren, vorzugsweise vom Anreicherungstyp, realisiert werden.

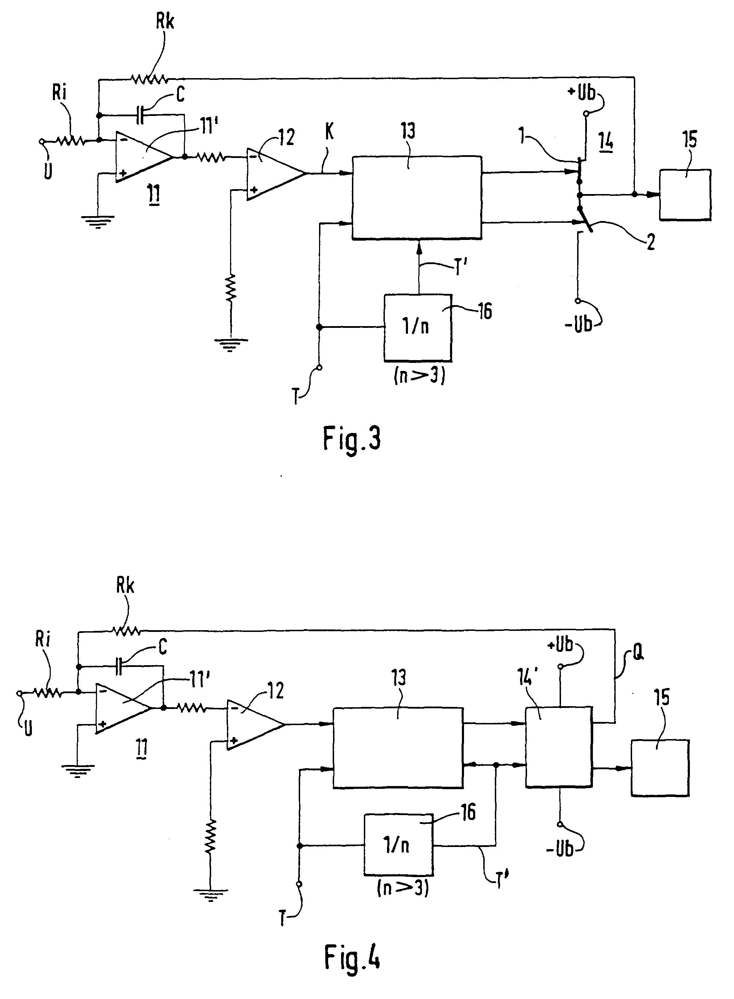

Beim Delta-Sigma-Analog/Digital-Wandler nach Fig. 2 ist anstatt der Serienschaltung 14 bei ansonsten gleichem Aufbau und gleichen Verhältnissen ein D-Flipflop 14' vorgesehen. Seine Versorgungsspannung ist die unipolare Referenzspannung Uu, und seinem Takteingang ist das Zusatztaktsignal T' zugeführt.
Beim Delta-Sigma-Analog/Digital-Wandler nach Fig. 3 liegt im Unterschied zu Fig. 1 die Serienschaltung 14 an den beiden Polen einer bipolaren, schaltungsnullpunkt-symmetrischen Referenzspannung Ub, deren beide Pole mit +Ub, -Ub bezeichnet sind. Daher ist der Referenzeingang des Integrierglieds 11 mit dem Schaltungsnullpunkt verbunden. Im übrigen stimmt der Aufbau der Schaltung von Fig. 3 mit dem von Fig. 1 überein.

Beim Delta-Sigma-Analog/Digital-Wandler nach Fig. 4 liegt im Unterschied zu Fig. 2 das D-Flipflop 14' an den beiden Polen der bipolaren, schaltungsnullpunkt-symmetrischen Referenzspannung Ub. Daher ist der Referenzeingang des Integrierglieds 11 wiederum mit dem Schaltungsnullpunkt verbunden. Im übrigen stimmt der Aufbau der Schaltung von Fig. 4 mit dem von Fig. 2 überein.

Nach einer vorteilhaften Ausgestaltung der Erfindung ist die Teilungszahl n des Frequenzteilers eine Zweierpotenz; n ist danach also mindestens gleich 4. Somit kann der Frequenzteiler 16 ein einfacher Binärteiler sein.

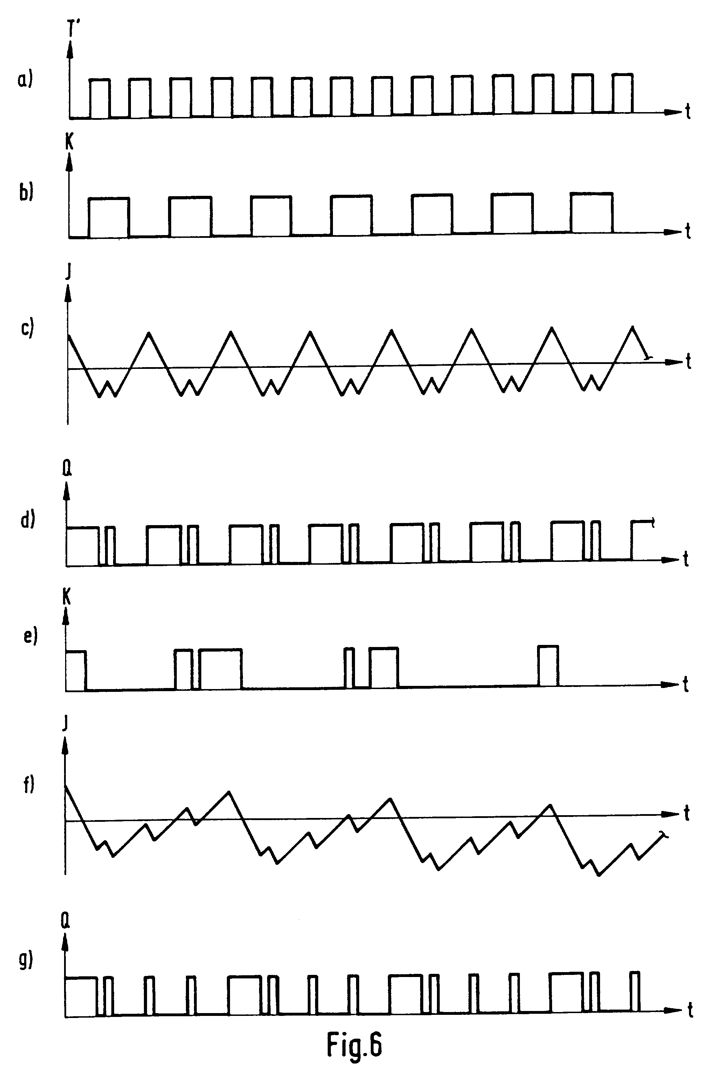

Die Fig. 5 und 6 dienen der Erläuterung der Funktionsweise der Erfindung. Fig.5 bezieht sich auf eine Anordnung nach der eingangs erwähnten Zeitschrift "rme", also auf eine Schaltung entsprechend Fig. 2, die jedoch keinen Pulsbreitenwähler 13 und keinen Frequenzteiler 16 enthält.

Die sechs Teilfiguren a) bis g) der Fig. 5 zeigen den jeweiligen Zeitverlauf folgender Signale:
a): Taktsignal T;
b) und e):Ausgangssignal K' des Komparators;
c) und f):Ausgangssignal J' des Integrierglieds;
d) und g):Ausgangssignal Q' des D-Flipflops.
Ferner gilt für:
b) bis d):Analogsignal gleich 1/2 mal Referenzspannung;
e) bis g):Analogsignal gleich 3/4 mal Referenzspannung.

Fig. 5d zeigt, daß im Falle Analogsignal gleich 1/2 mal Referenzspannung, wie eingangs erwähnt, die Frequenz des Ausgangssignals Q' genau halb so groß ist wie die des Taktsignals T, oder mit anderen Worten daß pro zwei Taktperioden zwei Polaritätswechsel des Ausgangssignals Q' auftreten.

Demgegenüber zeigt Fig. 5g, daß bei vom Fall der Fig. 5d abweichender Amplitude des Analogsignals, nämlich hier konkret Analogsignal gleich 3/4 mal Referenzspannung, die Frequenz des Ausgangsignals Q' kleiner ist als im Fall der Fig. 5d, nämlich nur ein Viertel der Frequenz des Taktsignals T beträgt, oder mit anderen Worten daß erst pro vier Taktperioden zwei Polaritätswechsel des Ausgangssignals Q' auftreten. Die Häufigkeit der Polaritätswechsel hat also gegenüber der von Fig. 5d abgenommen.

Die Zeitdiagramme der Fig. 5b und 5c bzw. 5e und 5f ergeben sich im übrigen aus denen der Fig. 5d bzw. 5g in leicht einsehbarer Weise aufgrund der jeweiligen Grundfunktion des Komparators und des Integrierglieds. So wird bei Fig. 5c der Kondensator des Integrierglieds mit derselben Geschwindigkeit aufge- und entladen. Bei Fig. 5f dauert dagegen die Aufladung des Kondensators dreimal so lange wie dessen Entladung. Da nur während der positiven Anteile des Signals J' das Signal K' entsteht, ist auch die Frequenz der Impulse K' von Fig. 5e wesentlich kleiner als die der Impulse K' von Fig. 5b.

Die sechs Teilfiguren a) bis g) der Fig. 6 zeigen den jeweiligen Zeitverlauf folgender Signale der Schaltung nach Fig. 2:
a): Taktsignal T' bei einer Teilungszahl n des Frequenzteilers 16 von 4;
b) und e):Ausgangssignal K des Komparators 12;
c) und f):Ausgangssignal J des Integrierglieds 11;
d) und g):Ausgangssignal Q des D-Flipflops 14'.
Ferner gilt:
b) bis d):Analogsignal U gleich 1/2 mal Referenzspannung Uu;
e) bis g):Analogsignal U gleich 3/4 mal Referenzspannung Uu.

Fig. 6b zeigt, daß im Falle Analogsignal U gleich 1/2 mal Referenzspannung Uu die Frequenz des Ausgangssignals K zwar wieder genau halb so groß ist wie die des Taktsignals T', daß jedoch wegen des Pulsbreitenwählers 13, wie Fig. 6d zeigt, das Signal Q am Ausgang des D-Flipflpops 14' aus Doppelimpulsen besteht, und zwar aus einem breiten und einem schmalen Impuls. Wegen n = 4 ist die Breite des schmalen Impulses gleich der Periodendauer des Taktsignals T, während die des breiten Impulses gleich (n - 1)mal, also dreimal, so groß ist.

Die schmalen Impulse bewirken die im Negativen liegenden und in Fig. 6c als kleine aufwärtsgerichtete Zacken zu sehenden Umkehrungen des Auf/Entladevorgangs des Kondensators C des Integrierglieds 11. Pro zwei Taktperioden des Zusatztaksignals T' entstehen somit in Fig. 6d zwar vier Polaritätswechsel des Ausgangssignals Q' (anstatt zwei wie bei Fig. 5d), jedoch ist zu berücksichtigen, daß die Frequenz von T' nur ein Viertel der Frequenz von T ist. Somit ist die Häufigkeit der Polaritätswechsel um die Teilungszahl 4, also allgemein um n, reduziert.

Die Fig. 5e bis 5g zeigen, daß bei vom Fall der Fig. 6b abweichender Amplitude des Analogsignals U, nämlich hier konkret Analogsignal U gleich 3/4 mal Referenzspannung Uu, die Frequenz des Ausgangsignals Q' sich gegenüber der von Fig. 6b nicht verändert, sondern daß lediglich die Anzahl der breiten und der schmalen Impulsanteile im Ausgangssignal Q von Fig. 6g sich innerhalb von vier Periodendauern des Taktsignals T' ändert. Während in Fig. 6d zwei breite und zwei schmale Impulse auftreten, sind dies in Fig. 6g ein breiter und drei schmale Impulse. Die Anzahl der Polaritätswechsel bleibt also bei der Erfindung über den Amplitudenbereich des Analogsignals U zusätzlich zu der oben erwähnten starken Reduzierung um n auch noch konstant.

Aufgrund der eben geschilderten, im Vergleich zu Fig. 6d größeren Anzahl von schmalen Impulsanteilen erscheinen im Ausgangssignal J nach Fig. 6f daher auch entsprechend mehr als kleine aufwärtsgerichtete Zacken zu sehende Umkehrungen des Auf/Entladevorgangs des Kondensators C des Integrierglieds 11, nämlich entsprechend der Zahl schmaler Impulsanteile (n - 1) = 3 pro vier Periodendauern des Zusatztaktsignals T'.

## Patentansprüche

1. Delta-Sigma-Analog/Digital-Wandler mit
- einem Integrierglied (11), dessen Signaleingang über einen Integrierwiderstand (Ri) ein Zu wandelndes Analogsignal (U) zugeführt ist,
- einem Komparator (12), dessen Komparator-Eingang am Ausgang des Integrierglieds (11) und dessen Referenzeingang am Schaltungsnullpunkt liegt,
- einem Pulsbreitenwähler (13),
-- der in Abhängigkeit vom Pegel des Ausgangssignals des Komparators (12) einen schmalen oder einen breiten Impuls erzeugt,
-- dessen Signaleingang am Ausgang des Komparators (12) liegt und
-- dessen erstem Takteingang ein Taktsignal (T) sowie dessen zweitem Takteingang ein durch Frequenzteilung mit einer Teilungszahl n > 3 aus dem Taktsignal (T) abgeleitetes Zusatztaktsignal (T') zugeführt ist, und
- einer Serienschaltung (14) eines ersten und eines zweiten elektronischen Schalters (1, 2),
-- die entweder zwischen einer unipolaren Referenzspannung (Uu) und dem Schaltungsnullpunkt oder zwischen den beiden Polen einer bipolaren, schaltungsnullpunktsymmetrischen Referenzspannung (Ub) liegt,
-- bei der der Steuereingang des ersten elektronischen Schalters (1) am nichtinvertierten und der des zweiten elektronischen Schalters (2) am invertierten Ausgang des Pulsbreitenwählers (13) liegt und
-- bei der der Verbindungspunkt der elektronischen Schalter (1, 2) mit einer Weiterverarbeitungsanordnung (15) sowie über einen Rückkopplungswiderstand (Rk) mit dem Signaleingang des Integrierglieds (11) verbunden ist,
- wobei entweder dem Referenzeingang des Integrierglieds im Falle der unipolaren Referenzspannung (Uu) derjenige Teilbetrag (Uu') zugeführt ist, der gleich [Ri/(Ri+Rk)]Uu/2 ist, oder der Referenzeingang im Falle der bipolaren Referenzspannung (Ub) am Schaltungsnullpunkt liegt und
- wobei die Breite des vom Pulsbreitenwähler (13) erzeugten schmalen Impulses gleich der Periodendauer des Taktsignals (T) und die Breite des vom Pulsbreitenwähler (13) erzeugten breiten Impulses gleich der (n - 1)fachen Periodendauer des Taktsignals (T) ist.

2. Delta-Sigma-Analog/Digital-Wandler mit
- einem Integrierglied (11), dessen Signaleingang über einen Integrierwiderstand (Ri) ein zu wandelndes Analogsignal (U) zugeführt ist,
- einem Komparator (12), dessen Komparator-Eingang am Ausgang des Integrierglieds (11) und dessen Referenzeingang am Schaltungsnullpunkt liegt,
- einem Pulsbreitenwähler (13),
-- der in Abhängigkeit vom Pegel des Ausgangssignals des Komparators (12) einen schmalen oder einen breiten Impuls erzeugt,
-- dessen Signaleingang am Ausgang des Komparators (12) liegt und
-- dessen erstem Takteingang ein Taktsignal (T) sowie dessen zweitem Takteingang ein durch Frequenzteilung mit einer Teilungszahl n > 3 aus dem Taktsignal (T) abgeleitetes Zusatztaktsignal (T') zugeführt ist, und
- einem D-Flipflop (14'),
-- dessen D-Eingang mit dem Ausgang des Pulsbreitenwählers (13) verbunden ist,
-- dessen nichtinvertiertes Ausgangssignal über einen Rückkopplungswiderstand (Rk) mit dem Eingang des Integrierglieds (11) verbunden ist,
-- dessen Takteingang das Zusatztaktsignal (T') sowie
-- dessen invertiertes Ausgangssignal einer Weiterverarbeitungsanordnung (15) zugeführt ist und
-- dessen Betriebsspannung entweder eine unipolare Referenzspannung (Uu) oder eine bipolare, schaltungsnullpunkt-symmetrische Referenzspannung (Ub) ist,
- wobei entweder dem Referenzeingang des Integrierglieds im Falle der unipolaren Referenzspannung (Uu) derjenige Teilbetrag (Uu') zugeführt ist, der gleich [Ri/(Ri+Rk)]Uu/2 ist, oder der Referenzeingang im Falle der bipolaren Referenzspannung (Ub) am Schaltungsnullpunkt liegt und
- wobei die Breite des vom Pulsbreitenwähler (13) erzeugten schmalen Impulses gleich der Periodendauer des Taktsignals (T) und die Breite des vom Pulsbreitenwähler (13) erzeugten breiten Impulses gleich der (n - 1)fachen Periodendauer des Taktsignals (T) ist.

3. Delta-Sigma-Analog/Digital-Wandler nach Anspruch 2 mit einer Teilungszahl n, die eine Zweierpotenz ist.

## Claims

1. A delta-sigma analog-to-digital converter comprising
- an integrator (11) whose signal input is supplied through an integrating resistor (Ri) with an analog signal (U) to be converted,
- a comparator (12) having its comparator input connected to the output of the integrator (11) and its reference input grounded,
- a pulse-width selector (13)
-- which provides a narrow or wide pulse depending on the level of the comparator output signal,
-- whose signal input is connected to the output of the comparator (12), and
-- whose first clock input is supplied with a ciock signal (T), and whose second clock input is supplied with an additional clock signal (T') derived from the clock signal (T) by frequency division with a divisor n > 3, and
- a series combination (14) of a first and a second electronic switch (1, 2)
- which is connected either between a unipolar reference voltage (Uu) and ground or between the two terminals for a bipolar, balanced-to-ground reference voltage (Ub),
-- in which the control inputs of the first and second electronic switches (1, 2) are connected to the noninverted and inverted outputs, respectively, of the pulse-width selector (13), and
-- in which the junction of the electronic switches (1, 2) is connected to a further-processing arrangement (15) and through a feedback resistor (Rk) to the signal input of the integrator (11),
- wherein the reference input is, in the case of the unipolar reference voltage (Uu), fed with that portion (Uu') of this voltage which is equal to [Ri/(Ri+Rk)]Uu/2, or, in the case of the bipolar reference voltage (Ub), connected to ground, and
- wherein the width of the narrow pulse provided by the pulse-width selector (13) is equal to the period of the clock signal (T), while the width of the wide pulse provided by the pulse-width selector (13) is equal to (n - 1) times the period of the clock signal.

2. A delta-sigma analog-to-digital converter comprising
- an integrator (11) whose signal input is supplied through an integrating resistor (Ri) with an analog signal (U) to be converted,
- a comparator (12) having its comparator input connected to the output of the integrator (11) and its reference input grounded,
- a pulse-width selector (13)
-- which provides a narrow or wide pulse depending on the level of the comparator output signal,
-- whose signal input is connected to the output of the comparator (12), and
-- whose first clock input is supplied with a ciock signal (T), and whose second clock input is supplied with an additional clock signal (T') derived from the clock signal (T) by frequency division with a divisor n > 3, and
- a D flip-flop (14')
-- whose D input is connected to the output of the pulse-width selector (13) ,
-- whose noninverted output is coupled through a feedback resistor (Rk) to the input of the integrator,
-- whose clock input is supplied with the additional clock signal (T'),
-- whose inverted output is coupled to a further-processing arrangement (15), and
-- whose operating voltage is either a unipolar reference voltage (Uu) or a bipolar reference voltage (Ub) balanced with respect to ground,
- wherein the reference input is, in the case of the unipolar reference voltage (Uu), fed with that portion (Uu') of this voltage which is equal to [Ri/(Ri+Rk)]Uu/2, or, in the case of the bipolar reference voltage (Ub), connected to ground, and
- wherein the width of the narrow pulse provided by the pulse-width selector (13) is equal to the period of the clock signal (T), while the width of the wide pulse provided by the pulse-width selector (13) is equal to (n - 1) times the period of the clock signal.

3. A delta-sigma analog-to-digital converter as claimed in claim 2 wherein the divisor n is a power of two.

## Revendications

1. Convertisseur analogique/numérique delta-sigma comprenant
- un circuit d'intégration (11), auquel est appliqué à son entrée de signal, un signal analogique (U) à convertir, via une résistance du circuit d'intégration (Ri);
- un comparateur (12), dont l'entrée du comparateur se trouve à la sortie du circuit d'intégration (11), et dont l'entrée de référence se trouve au niveau du point zéro du circuit;
- un sélecteur de largeur d'impulsion (13):
-- qui, en fonction du niveau du signal de sortie du comparateur (12), produit une impulsion étroite ou large,
-- dont l'entrée du signal se trouve à la sortie du comparateur (12) et
-- à la première entrée d'horloge duquel est appliqué un signal d'horloge (T), et à la seconde entrée d'horloge duquel est appliqué un signal d'horloge supplémentaire (T'), issu du signal d'horloge (T) et obtenu par division de fréquence avec un dividende n > 3; et
- un montage série (14) d'un premier et d'un second interrupteur électronique (1, 2),
-- qui se trouve soit entre une tension de référence unipolaire (Uu) et le point zéro du montage, soit entre les deux pôles d'une tension de référence bipolaire (Ub), symétrique au point zéro du montage,
-- dont l'entrée de commande du premier interrupteur électronique (1) se trouve au niveau de la sortie non inversée du sélecteur de largeur d'impulsion (13) et dont l'entrée de commande du second interrupteur électronique (2) se trouve au niveau de la sortie inversée de ce même sélecteur, et
-- dans lequel le point de connexion des interrupteurs électroniques (1, 2) est relié à une configuration de traitement (15), ainsi qu'à l'entrée de signal du circuit d'intégration (11), via une résistance de contre-réaction (Rk);
- où, soit on applique à l'entrée de référence du circuit d'intégration, dans le cas de la tension de référence unipolaire (Uu), le montant partiel (Uu') qui est égal à [Ri/(Ri+Rk)]Uu/2, soit l'entrée de référence, dans le cas de la tension de référence bipolaire (Ub), se trouve au niveau du point zéro du montage, et
- où la largeur de l'impulsion étroite, produite par le sélecteur de largeur d'impulsion (13), est égale à la longueur de période du signal d'horloge (T), et où la largeur de l'impulsion large, produite par le sélecteur de largeur d'impulsion (13), est égale à (n-1) fois la longueur de période du signal d'horloge (T).

2. Convertisseur analogique/numérique delta-sigma comprenant
- un circuit d'intégration (11), à l'entrée de signal duquel est appliqué un signal analogique à convertir (U) via une résistance du circuit d'intégration (Ri),
- un comparateur (12), dont l'entrée du comparateur se trouve à la sortie du circuit d'intégration (11) et dont l'entrée de référence se trouve au niveau du point zéro du montage,
- un sélecteur de largeur d'impulsion (13):
-- qui produit une impulsion étroite ou large en fonction du niveau du signal de sortie du comparateur (12),
-- dont l'entrée du signal se trouve à la sortie du comparateur (12) et
-- à la première entrée d'horloge duquel est appliqué un signal d'horloge (T), et à la seconde entrée d'horloge duquel est appliqué un signal d'horloge supplémentaire (T'), issu du signal d'horloge (T) et obtenu par division de fréquence avec un dividende n > 3; et
- une bascule flip-flop du type D (14'),
-- dont l'entrée du type D est reliée à la sortie du sélecteur de largeur d'impulsion (13),
-- dont le signal de sortie non inversé est relié à l'entrée du circuit d'intégration (11), via une résistance de contre-réaction (Rk),
-- à l'entrée d'horloge de laquelle est appliqué le signal d'horloge supplémentaire (T'), et
-- dont le signal de sortie inversé est appliqué à une configuration de traitement (15), et
-- dont la tension de fonctionnement est soit une tension de référence unipolaire (Uu), soit une tension de référence bipolaire (Ub), symétrique au point zéro du montage,
- où, soit on applique à l'entrée de référence du circuit d'intégration, dans le cas de la tension de référence unipolaire (Uu), le montant partiel (Uu') qui est égal à [Ri/(Ri+Rk)]Uu/2, soit l'entrée de référence, dans le cas de la tension de référence bipolaire (Ub), se trouve au niveau du point zéro du montage, et
- où la largeur de l'impulsion étroite, produite par le sélecteur de largeur d'impulsion (13), est égale à la longueur de période du signal d'horloge (T), et où la largeur de l'impulsion large, produite par le sélecteur de largeur d'impulsion (13), est égale à (n-1) fois la longueur de période du signal d'horloge (T).

3. Convertisseur analogique/numérique delta-sigma selon la revendication 2, avec un dividende n qui est une puissance de deux.
